# EUROPÄISCHE PATENTSCHRIFT

(11) **EP 2 678 909 B1**
(45) Veröffentlichungstag und Bekanntmachung des Hinweises auf die Patenterteilung: **01.04.2015**
(21) Anmeldenummer: 12705624.0
(22) Anmeldetag: 22.02.2012
(51) Int. Cl.: H02B 1/28, H02B 1/30, H05K 9/00, H02B 1/01

(54) **DICHTELEMENT UND DICHTUNGSSYSTEM FÜR HOHLPROFILE**
SEALING DEVICE AND SEALING SYSTEM FOR HOLLOW PROFILE
ÉLÉMENT D'ÉTANCHÉITÉ ET SYSTÈME D'ÉTANCHÉITÉ POUR PROFILÉ CREUX

(30) Priorität: 25.02.2011 DE 102011012433; 25.02.2011 DE 102011012436; 25.02.2011 DE 102011012434; 25.02.2011 DE 102011012435
(43) Veröffentlichungstag der Anmeldung: 01.01.2014
(73) Patentinhaber: C E S Control Enclosure Systems GmbH, 61348 Bad Homburg v. d. Höhe (DE)
(72) Erfinder: SCHAAF, Igor Harry, 77836 Rheinmünster (DE); MAZURA, Paul, 76307 Karlsbad (DE); NICOLAI, Walter, 35418 Buseck (DE); JOCHAM, Simon, 80469 München (DE)
(74) Vertreter: Beyer, Andreas
(86) Internationale Anmeldenummer: PCT/EP2012/000769
(87) Internationale Veröffentlichungsnummer: WO 2012/113551

(56) Entgegenhaltungen:
- EP-A1- 0 402 276
- WO-A1-2005/052416
- DE-A1-102008 020 148
- DE-C1- 19 853 611
- DE-U1- 8 912 397
- DE-U1- 29 517 327
- US-A- 5 775 051
- US-A1- 2009 260 311

## Beschreibung

Die Erfindung betrifft ein Dichtelement für Hohlprofile sowie ein solche Dichtelemente umfassendes Dichtungssystem für Hohlprofile.

Hohlprofile, die beispielsweise aus Metall oder Kunststoff bestehen können, eignen sich zur Herstellung von Rahmen und Gestellen, wie sie in verschiedenen Anwendungsgebieten benötigt werden, etwa in der Elektroindustrie (z.B. als Rahmenelemente für Schaltschränke), im Maschinen- und Anlagenbau (etwa als Maschinenuntergestell oder ähnliches), aber auch in der Möbelindustrie (beispielsweise für Regalsysteme und ähnliches). Hohlprofile der genannten Art können aus Metallblech geformt sein, es kann sich bei ihnen aber auch um Stranggussteile (etwa aus Aluminium oder aus Kunststoff) handeln. Unabhängig von der Art ihrer Herstellung und dem Material, aus dem sie bestehen, müssen die üblicherweise langgestreckten Hohlprofile jedoch an ihren Enden mit weiteren Hohlprofilen verbunden werden, um beispielsweise einen Rahmen, ein Gestell oder ähnliches zu bilden.

Häufig muss ein aus Hohlprofilen bestehendes Gestell oder ein Rahmen mit Seitenteilen versehen werden, um in dem Rahmen oder Gestell einen abgeschlossenen Innenraum zu schaffen. Soll dieser Innenraum zur Umgebung abgedichtet sein, müssen zwischen jedem Wandelement und dem Hohlprofil, an dem das Wandelement befestigt wird, Dichtungen vorgesehen werden. Hierzu kann beispielsweise jedes Wandelement auf seiner dem Hohlprofil zugewandten Innenseite mit einer Dichtung versehen sein, die beim Befestigen des Wandelements in abdichtende Anlage mit dem Hohlprofil kommt, oder es kann unmittelbar auf dem Hohlprofil eine Dichtung vorhanden sein, mit der das Wandelement zur Abdichtung in Kontakt kommt.

Die deutsche Patentschrift DE 198 53 611 C1 offenbart einen Schaltschrank mit einem Rahmengestell aus mehreren miteinander verbundenen Rahmenprofilen und daran befestigten Abdeckelementen. Jedes Rahmenprofil weist zwei im Abstand zueinander angeordnete, jeweils auf ein zugeordnetes Abdeckprofil aufdrückbare Dichtkanten bzw. -flächen auf.

Die veröffentlichte deutsche Patentanmeldung DE 10 2008 020 148 A1 offenbart ein Dichtungsprofil für Platten- oder Profilkörper, insbesondere für Portale von Nutz- und Schienenfahrzeugen. Das Dichtungsprofil umfasst ein Aluminiumprofil, das die Stützleiste des Dichtungsprofils bildet, sowie ein auf das Aluminiumprofil montiertes Gummiprofil, das die Dichtleiste des Dichtungsprofils bildet. Gemäß einer Ausführungsform hat die Dichtleiste Dichtlippen an den freien Enden der Schenkel des Dichtungsprofils. Die Dichtleiste wird mittels einer Schraube am Profilkörper befestigt.

Der Erfindung liegt die Aufgabe zugrunde, eine einfach zu montierende und funktionell überzeugende Lösung anzugeben, die es gestattet, ein Hohlprofil wahlweise mit einer Dichtung auszustatten, um z.B. einen Staub- und/oder Feuchtigkeitseintritt in einen durch eine Anordnung von Hohlprofilen gebildeten Innenraum zu verhindern, wobei optional zusätzlich auch eine elektromagnetische Abschirmung ermöglicht sein soll (zur Erzielung einer sogenannten elektromagnetischen Verträglichkeit, abgekürzt EMV).

Diese Aufgabe ist erfindungsgemäß mit einem Dichtelement für Hohlprofile gemäß Anspruch 1 gelöst.

Erfindungsgemäß wird somit eine erforderliche Abdichtung nicht an einem zu befestigenden Wandelement und auch nicht unmittelbar an einem Hohlprofil selbst vorgesehen. Stattdessen wird die gegebenenfalls erforderliche Abdichtung erreicht durch ein zusätzliches Dichtelement, das an einem Eckbereich eines Hohlprofils befestigbar ist und auf seiner Außenseite an oder nahe den freien Längsrändern mit Dichtungen versehen ist, die eine gewünschte Abdichtung zwischen einem Hohlprofil und einem daran zu befestigenden Wandelement bewirken. Erfindungsgemäße Dichtelemente können als Meterware hergestellt und in jeder gewünschten Länge vorkonfektioniert werden. Hohlprofile, die später eine Abdichtung aufweisen sollen, unterscheiden sich erfindungsgemäß nicht von solchen Hohlprofilen, die ohne eine Abdichtung zum Einsatz gelangen. Vielmehr kann je nach Bedarf entschieden werden, ob eine Abdichtung vorhanden sein soll oder nicht, indem erfindungsgemäße Dichtelemente zum Einsatz kommen oder nicht. Eine Abdichtung kann gegebenenfalls auch nachträglich noch erfolgen, wobei lediglich bereits montierte Wandelemente von einem Hohlprofilrahmen abgenommen und nach Anbringen der Dichtelemente wieder befestigt werden müssen.

Bei manchen Ausführungsformen erfindungsgemäßer Dichtelemente ist der freie Längsrand jedes Schenkels mit einem Dichtungsmaterial umspritzt, etwa mit einem geeigneten Elastomermaterial. Auf diese Weise erfolgt eine Abdichtung sowohl auf der Außenseite als auch auf der Innenseite jedes Schenkels. Bei anderen Ausführungsformen sind die Dichtungen nur auf der Außenseite des zugehörigen Schenkels angebracht. Eine Anbringung der Dichtungen an dem Schenkel kann durch Kleben, Klemmen, Verschmelzen oder eine andere geeignete Befestigungsart erfolgen.

Bei dem erfindungsgemäßen Dichtelement bestehen die zwei Schenkel aus elastischem Material und der zwischen den beiden Schenkeln gebildete Eckwinkel ist etwas kleiner als ein Eckwinkel, der durch die Ecke des Hohlprofils gebildet ist, auf der das Dichtelement befestigt werden soll. Weist beispielsweise das Hohlprofil einen Eckbereich mit einem 90 Grad-Winkel auf, dann ist bei dieser Ausführungsform der Eckwinkel des Dichtelements etwas kleiner als 90 Grad. Die Befestigungseinrichtung ist durch wenigstens zwei Klemmflächen gebildet, von denen jeweils eine an der Innenseite jedes Schenkels ausgebildet ist. Jede Klemmfläche verläuft mit Abstand von den einander zugewandten Längsrändern der Schenkel parallel zur Längsachse des Dichtelements, wobei zwischen der Klemmfläche und der Innenseite des zugehörigen Schenkels ein Klemmwinkel eingeschlossen ist. Jede Klemmfläche ist somit dazu ausgestaltet, mit einer komplementären Auflagefläche auf der Außenseite des Hohlprofils zusammenzuwirken. Weil der zwischen den beiden Schenkeln des Dichtelements gebildete Eckwinkel etwas kleiner ist als der Eckwinkel des Hohlprofils, werden beim Aufdrücken des Dichtelements auf den Eckbereich des Hohlprofils die beiden Schenkel etwas auseinandergedrängt, wodurch eine Spannkraft erzeugt wird, die den ursprünglichen Zustand wieder herstellen möchte und deshalb jede Klemmfläche des Dichtelements gegen die zugehörige Auflagefläche des Hohlprofils presst. Das Dichtelement ist auf diese Weise klemmend auf dem Hohlprofil gehalten.

Bei manchen Ausführungsformen des erfindungsgemäßen Dichtelements ist zumindest eine Dichtung in einer längsverlaufenden Vertiefung auf der Außenseite des zugehörigen Schenkels angeordnet, wobei ein Längsrand der Vertiefung, der den einander zugewandten Längsrändern der Schenkel, an denen die beiden Schenkel miteinander verbunden sind, näher ist als der andere Längsrand, durch die Rückseite der Klemmfläche dieses Schenkels gebildet ist. Die Rückseite der Klemmfläche bildet auf diese Weise eine seitliche Abstützung für die Dichtung und sorgt zugleich für eine einwandfreie Positionierung der Dichtung. Der andere Längsrand der Vertiefung kann ebenfalls eine stützende und positionierende Funktion ausüben, braucht dies aber nicht zu tun, sondern kann auch in einer Ebene mit dem freien Längsrand des zugehörigen Schenkels angeordnet sein.

Gemäß einer bevorzugten Weiterbildung eines erfindungsgemäßen Dichtelements ragt von der Außenseite zumindest eines der Schenkel ein Steg hervor, der sich parallel zur Längsachse erstreckt und zwischen sich und der Außenseite des zugehörigen Schenkels einen Federwinkel von weniger als 90 Grad einschließt. Der Steg ragt also nicht normal zur Außenseite des Schenkels hervor, sondern ist zum einen oder zum anderen Längsrand des Schenkels geneigt, vorzugsweise zu dem Längsrand, an dem die beiden Schenkel einstückig miteinander verbunden sind. Der Steg ist dabei so angeordnet, dass die ebenfalls auf dem Schenkel angeordnete Dichtung sich näher am freien Längsrand des zugehörigen Schenkels befindet als der Steg. Dadurch wird erreicht, dass in montiertem Zustand des Dichtelements die Dichtung sich quasi hinter dem Steg befindet, der Steg die Dichtung also schützen kann, etwa vor einer mechanischen Beschädigung, vor strahlartig auftreffender Flüssigkeit etc. Vorzugsweise ist das Maß, um welches der Steg hervorragt, so gewählt, dass ein zu befestigendes Wandelement zuerst mit dem freien Längsrand des Stegs in Berührung kommt und erst danach, d.h. im Laufe der weiteren Befestigung des Wandelements, mit der auf dem Steg befindlichen Dichtung. Der Steg wird also von einem zu befestigenden Wandelement etwas in Richtung auf das Dichtelement gedrückt, wodurch sein freier Längsrand sich federnd elastisch an die Innenseite des Wandelements anlegt.

Wenn zusätzlich zu einer Abdichtung beispielsweise gegen Staub und/oder Feuchtigkeit noch ein Schutz gegen elektromagnetische Strahlung (EMV) gewünscht ist, besteht ein erfindungsgemäßes Dichtelement vorzugsweise aus einem elektrisch leitenden Material, etwa aus einem Metall oder aus einem elektrisch leitfähigen Kunststoff. Alternativ ist es möglich, wenn das Dichtelement aus einem nicht elektrisch leitenden Material besteht, auf seine Außenseite einschließlich der Dichtungen eine elektrisch leitende Schicht aufzubringen. Dies kann eine Folie sein, die geeignet aufgebracht ist, vorzugsweise kann die elektrisch leitende Schicht jedoch aufgedampft sein. Unabhängig von den zuvor beschriebenen, eine elektrische Leitfähigkeit sicherstellenden Ausführungsformen wird auf diese Weise erreicht, dass der Innenraum, der durch die Anordnung aus Hohlprofilen gebildet ist, nach Art eines Faradayschen Käfigs geschützt ist, wenn die zu befestigenden Wandelemente ebenfalls elektrisch leitend sind.

Wenn das Material, aus dem ein erfindungsgemäßes Dichtelement hergestellt werden soll, dazu geeignet ist, extrudiert zu werden, dann sind bevorzugte Ausführungsformen erfindungsgemäßer Dichtelemente als ein sogenanntes 2K-Extrusionsteil ausgeführt. Mit dem Begriff "2K-Extrusionsteil" ist ein mittels eines einzigen Extrusionsvorgangs hergestelltes Teil gemeint, dessen Material aus zwei Komponenten besteht, von denen die eine Komponente ein härteres und stabileres Material ist, welches den Dichtungsträger einschließlich gegebenenfalls von ihm hervorragender Stege bildet, und von denen die zweite Komponente ein federnd elastisches Material ist, aus dem die Dichtungen gebildet sind. Fachleuten sind diese Zweikomponenten-Extrusionsverfahren bekannt, so dass hier nicht näher erläutert zu werden braucht, wie ein solches Extrusionsverfahren auszuführen ist.

Wenn aus Hohlprofilen Rahmen oder Gestelle gebildet werden, können zur Verbindung mehrerer Hohlprofile an einer Rahmen- oder Gestellecke sogenannte Eckverbinder zum Einsatz kommen, wie sie etwa in der deutschen Patentanmeldung desselben Anmelders mit dem Titel "Eckverbinder für Hohlprofile" beschrieben sind. Damit auch in solchen Eckbereichen eine einwandfreie Abdichtung und, falls gewünscht, ein Schutz gegen elektromagnetische Strahlung (EMV) gewährleistet ist, kommt erfindungsgemäß in jedem dieser Eckbereiche, in denen mehrere Hohlprofile mittels eines Eckverbinders verbunden sind, eine Abdeckkappe zum Einsatz, die auf ihrer Außenseite mit einer oder mehreren Dichtungsabschnitten versehen ist, die zur Verbindung mit Enden der Dichtungen ausgebildet sind, die auf dem Dichtelement vorhanden sind. Erfindungsgemäße Dichtelemente und wenigstens eine erfindungsgemäße Abdeckkappe bilden somit ein Dichtungssystem für Hohlprofile, welches sich einfach montieren und demontieren lässt und einen Rundumschutz gegen unerwünschte Umwelteinflüsse bietet. Jede Abdeckkappe ist vorzugsweise so ausgestaltet, dass sie auf den Eckverbinder aufsteckbar ist, wobei die Außenflächen der Abdeckkappe sich in derselben Ebene wie angrenzende Oberflächen der mittels des Eckverbinders verbundenen Hohlprofile befinden. Die Außenseiten der Abdeckkappe setzen somit den Verlauf der Hohlprofiloberflächen fort und bilden die eigentliche Rahmen- oder Gestellecke. Die auf der Außenseite der Abdeckkappe angebrachten Dichtungsabschnitte können zur Verbindung mit den Dichtungen eines Dichtelements Fortsätze aufweisen, die in einen inneren Hohlraum einer Dichtung eines Dichtelements einführbar sind.

Vorzugsweise besteht eine erfindungsgemäße Abdeckkappe einschließlich der auf ihr vorhandenen Dichtungsabschnitte aus einem elektrisch leitenden Material, damit ein Schutz gegen elektromagnetische Strahlung (EMV) ermöglicht ist. Alternativ kann zu diesem Zweck eine elektrisch leitende Schicht auf die Außenseite der Abdeckkappe einschließlich ihrer Dichtungsabschnitte aufgebracht sein.

Ein derzeit bevorzugtes Ausführungsbeispiel eines erfindungsgemäßen Dichtungssystems für Hohlprofile wird im Folgenden anhand der beigefügten, schematischen Zeichnungen näher erläutert. Es zeigt:
- Figur 1: ein Dichtelement für ein Hohlprofil in räumlicher Darstellung,
- Figur 2: eine Endansicht des Dichtelements aus Figur 1,
- Figur 3: einen Querschnitt durch ein Hohlprofil mit daran angebrachtem Dichtelement gemäß Figur 1, wobei an dem Hohlprofil ferner zwei Wandelemente befestigt sind,
- Figur 4: eine Abdeckkappe zur Ergänzung einer mittels Dichtelementen aus Figur 1 erreichten Abdichtung, und
- Figur 5: eine räumliche, auseinandergezogene Darstellung eines Rahmeneckbereichs bestehend aus drei Hohlprofilen, die durch einen Eckverbinder miteinander verbunden sind.

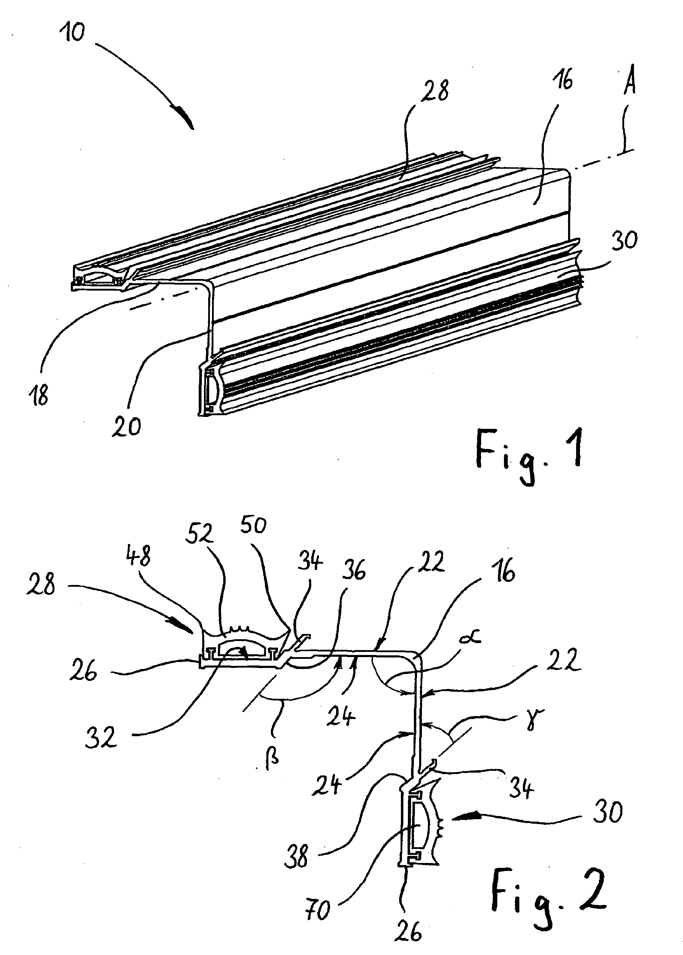

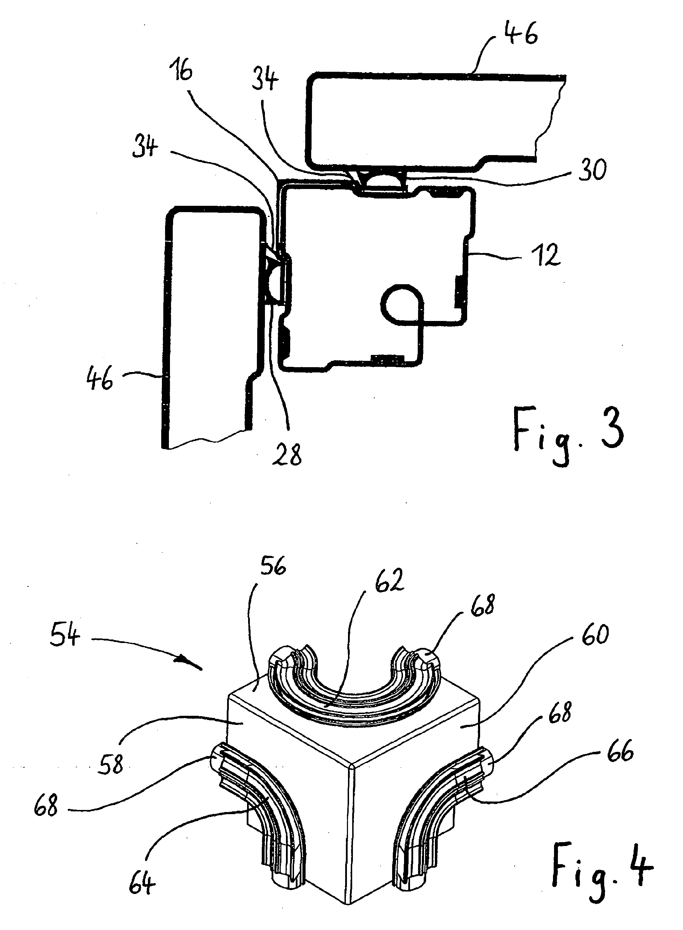

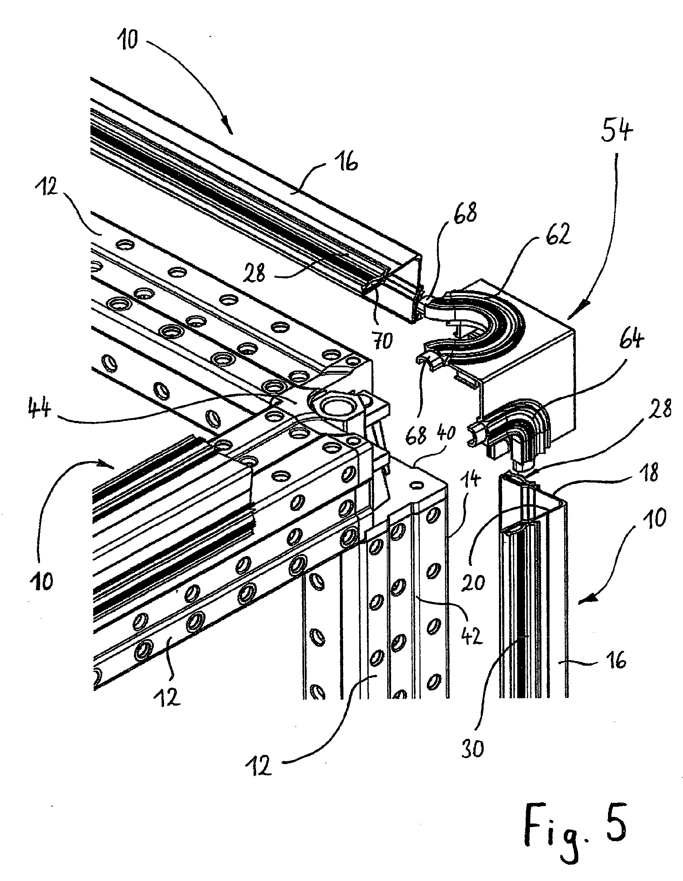

Die Figuren 1 und 2 zeigen ein allgemein mit 10 bezeichnetes Dichtelement für ein Hohlprofil 12, wie es beispielsweise in den Figuren 3 und 5 dargestellt ist. Das Dichtelement 10 ist wie aus Fig. 2 ersichtlich dazu gedacht, auf eine eine Ecke bildende seitliche Kante 14 des Hohlprofils 12 aufgesetzt zu werden.

Das Dichtelement 10 weist einen Dichtungsträger 16 auf, der sich entlang einer Längsachse A erstreckt und aus zwei Schenkeln 18, 20 gebildet ist, die je eine Außenseite 22 und eine Innenseite 24 aufweisen. Die beiden Schenkel 18, 20 sind an einander zugewandten Längsrändern einstückig miteinander so verbunden, dass sie zwischen sich einen Eckwinkel α einschließen, der im gezeigten Ausführungsbeispiel etwas kleiner als 90 Grad ist.

Angrenzend an einen freien Längsrand 26 jedes Schenkels 18, 20 ist auf der Außenseite 22 eine parallel zur Längsachse A und damit parallel zum freien Längsrand 26 verlaufende Dichtung 28, 30 angebracht, deren Funktion später noch näher erläutert werden wird. Jede Dichtung 28, 30 ist im gezeigten Ausführungsbeispiel in einer längsverlaufenden Vertiefung 32 aufgenommen und abgestützt.

Parallel zu einem inneren, den miteinander verbundenen Längsrändern der Schenkel 18, 20 näheren Längsrand jeder Vertiefung 32 steht nahe der Dichtung 28 bzw. 30 ein Steg 34 von der Außenseite 22 des Schenkels 18 bzw. 20 nach oben hervor. Der Steg 34 verläuft parallel zur Längsachse A und damit parallel zur Dichtung 28 bzw. 30 und ist so angeordnet, dass zwischen ihm und der Außenseite 22 des zugehörigen Schenkels 18, 20 ein Federwinkel γ von weniger als 90 Grad gebildet ist. Die Funktion dieser Stege 34, die in einem unverformten Zustand etwas über die zugehörige Dichtung 28, 30 hinausragen, wird noch erläutert werden.

Auf der Innenseite 24 jedes Schenkels 18, 20 ist jeweils eine schräg zum zugehörigen Schenkel angeordnete Klemmfläche 36, 38 ausgebildet, die mit Abstand von den miteinander verbundenen Längsrändern der Schenkel 18, 20 parallel zur Längsachse A verläuft und zwischen sich und der Innenseite 24 des zugehörigen Schenkels 18, 20 einen Klemmwinkel β einschließt. Diese Klemmflächen 36, 38 wirken, wie später noch erläutert werden wird, mit Auflageflächen 40, 42 auf der Außenseite des Hohlprofils 12 zusammen, um das Dichtelement 10 am Hohlprofil 12 zu befestigen. Die auf der Außenseite 22 befindlichen Rückseiten der Klemmflächen 36, 38 bilden im gezeigten Ausführungsbeispiel den inneren Längsrand der Vertiefungen 32.

Grundsätzlich kann der Dichtungsträger 16 aus einer Reihe unterschiedlicher Materialien hergestellt sein. Beispielsweise kann es sich beim Dichtungsträger 16 um ein Teil aus Stahl oder auch um ein Aluminiumprofil oder ein Profil aus einem anderen Metall handeln. Die Dichtungen 28, 30 können separate Bauteile sein, die in die Vertiefungen 32 eingelegt oder in ihnen festgeklemmt oder festgeklebt sind. Andere Befestigungsarten für die Dichtungen 28, 30 sind ebenfalls möglich.

Im gezeigten Ausführungsbeispiel besteht der Dichtungsträger 16 aus einem für den jeweiligen Verwendungszweck geeigneten, stabilen und gleichzeitig elastischen Kunststoff und ist zusammen mit den Dichtungen 28, 30 als ein sogenanntes Zweikomponenten-Extrusionsteil hergestellt. Die Dichtungen 28, 30 bestehen dabei aus einem anderen Material als der Dichtungsträger 16, vorzugsweise aus einem für die Herstellung von elastischen Dichtungen bekannten Elastomermaterial. Aufgrund des einheitlichen Extrusionsprozesses, mit dem sowohl der Dichtungsträger 16 als auch die Dichtungen 28, 30 zusammen erzeugt werden, sind die Dichtungen 28, 30 aufgrund der während der Extrusion herrschenden Temperatur bereits mit dem Dichtungsträger 16 verschmolzen und brauchen nicht mehr gesondert befestigt zu werden. Mittels eines solchen Zweikomponenten-Extrusionsverfahrens können Dichtelemente 10 quasi endlos hergestellt werden und danach in gewünschte Längen geschnitten werden.

Unter besonderer Bezugnahme auf die Figuren 3 und 5 wird nun die Funktion von Dichtelementen 10 näher erläutert. Fig. 5 zeigt hierzu drei Hohlprofile 12, die paarweise im rechten Winkel zueinander angeordnet sind und die Ecke eines nicht weiter dargestellten Rahmens bilden. Zur Verbindung der drei Hohlprofile 12 im Eckbereich dient beispielhaft ein Eckverbinder 44, wie er in der deutschen Patentanmeldung desselben Anmelders mit dem Titel "Eckverbinder für Hohlprofile" gezeigt und beschrieben ist, der jedoch auch anders aufgebaut sein kann, solange sichergestellt ist, dass er die drei Hohlprofile 12 zuverlässig und stabil miteinander verbindet.

Die Fig. 3 zeigt einen Schnitt durch das in Fig. 5 untere Hohlprofil 12 außerhalb des Bereiches, in dem der Eckverbinder 44 angeordnet ist, und lässt erkennen, dass im fertigen Zustand außen an den Hohlprofilen 12 Wandelemente 46 befestigt sind, die einen von dem Rahmen umgebenen Innenraum abschließen. Mittels der Dichtelemente 10 erfolgt eine zuverlässige Abschirmung dieses Innenraums vor Umgebungseinflüssen.

Um die gewünschte Abdichtung zu erzielen, wird auf die seitliche Kante 14 eines jeden Hohlprofils 12 ein Dichtelement 10 aufgesetzt, wie in Fig. 5 dargestellt. Da der Eckwinkel der Hohlprofile im gezeigten Beispiel 90 Grad beträgt, der Eckwinkel α der Dichtelemente 10 jedoch geringfügig kleiner ist, werden die Dichtelemente 10 beim Aufstecken auf die Hohlprofile 12 etwas aufgeweitet, d.h. die Schenkel 18, 20 werden etwas auseinandergedrückt. Weil das Material, aus dem der Dichtungsträger 16 besteht, elastisch ist, entsteht durch diese Aufweitung eine Federkraft, die die Schenkel 18, 20 aufeinander zu drängt und dadurch die Klemmflächen 36, 38 auf der Innenseite 24 des Dichtelements 10 gegen die Auflageflächen 40, 42 am Hohlprofil 12 presst. Mittels dieser Klemmwirkung ist jedes Dichtelement 10 sicher und dennoch leicht lösbar am Hohlprofil 12 gehalten.

Der montierte Zustand eines Dichtelements 10 ist aus Fig. 3 ersichtlich. Man erkennt, dass die Innenseite 24 des Dichtelements 10 komplementär zur Außenseite des Hohlprofils 12 ausgebildet ist, so dass sich das Dichtelement 10 an die Außenseite des Hohlprofils 12 anschmiegt. Sobald das Dichtelement 10 auf dem Hohlprofil 12 montiert ist, befinden sich die Dichtungen 28, 30 automatisch in einer Position, in der sie mit der Innenseite der Wandelemente 46 in Berührung kommen können.

Beim Befestigen eines Wandelements 46 am Hohlprofil 12 kommt die Innenseite des Wandelements 46 zuerst mit dem freien Rand des Stegs 34 in Kontakt. Im Laufe der weiteren Befestigung des Wandelements 46, die beispielsweise durch ein Anziehen hier nicht dargestellter Schrauben erfolgt, verringert sich der Abstand zwischen der Innenseite des Wandelements 46 und der Außenseite 22 des Dichtelements 10, so dass der Steg 34 etwas verformt wird, wodurch sich der Federwinkel γ etwas verkleinert. Wenn das Wandelement 46 vollständig an dem Hohlprofil 12 befestigt ist, wirkt somit in dem aus dem elastischen Material des Dichtungsträgers 16 bestehenden Steg 34 eine Federkraft, die den freien Längsrand des Stegs 34 gegen die Innenseite des Wandelements 46 drückt und auf diese Weise eine erste Abdichtung bildet, beispielsweise gegen Spritzwasser. Im vollständig am Hohlprofil 12 befestigten Zustand des Wandelements 46 ist auch die Außenseite der Dichtungen 28, 30 in federndem Kontakt mit der Innenseite des zugehörigen Wandelements 46, wodurch eine zweite Abdichtung gebildet ist, welche die eigentliche Abdichtung darstellt. Im gezeigten Ausführungsbeispiel ist jede Dichtung 28, 30 durch ein Dichtungshohlprofil gebildet, das auf seiner Außenseite zwei Dichtlippen 48, 50 und dazwischen einen konvex gekrümmten Dichtungsbereich 52 aufweist, dessen Außenseite sich in montiertem Zustand in linien- bzw. bandförmigem Kontakt mit der Innenseite eines Wandelements 46 befindet.

In den Figuren 4 und 5 ist ferner eine Abdeckkappe 54 gezeigt, die eine mittels der Dichtungselemente 10 erreichte Abdichtung ergänzt. Die Abdeckkappe 54 besteht aus drei einstückig miteinander und im rechten Winkel zueinander verbundenen Wandabschnitten 56, 58, 60, auf deren Außenseite jeweils ein Dichtungsabschnitt 62, 64, 66 befestigt ist, von denen in Fig. 5 nur die Dichtungsabschnitte 62 und 64 sichtbar sind. Das Material, aus dem die Wandabschnitte 56, 58, 60 der Abdeckkappe 54 gebildet sind, kann das gleiche Material sein, aus dem auch der Dichtungsträger 16 der Dichtungselemente 10 hergestellt worden ist, es kann jedoch auch ein vom Material des Dichtungsträgers 16 verschiedenes Material zum Einsatz kommen. Die Wandabschnitte 56, 58, 60 können beispielsweise auch aus Metall bestehen, obwohl das Material des Dichtungsträgers 16 im gezeigten Ausführungsbeispiel ein Kunststoff ist. Das Material, aus dem die Dichtungsabschnitte 62, 64, 66 bestehen, ist vorzugsweise das gleiche Material, aus dem auch die Dichtungen 28, 30 gefertigt sind.

Die Abdeckkappe 54 ist dazu ausgestaltet, auf dem Eckverbinder 44 befestigt zu werden, beispielsweise durch Verrasten. Im am Eckverbinder 44 befestigten Zustand setzen die Wandabschnitte 56, 58, 60 der Abdeckkappe 54 im Wesentlichen die zugehörigen äußeren Flächen der Hohlprofile 12 fort, die mittels des Eckverbinders 44 miteinander verbunden worden sind. Die eigentliche Ecke des durch die Hohlprofile 12 gebildeten Rahmens befindet sich somit an der Abdeckkappe 54 dort, wo alle drei Wandabschnitte 56, 58, 60 zusammenstoßen.

Wie dargestellt sind die Dichtungsabschnitte 62, 64, 66 solchermaßen gekrümmt ausgeführt, dass sie jeweils zwei Dichtungen 28 oder 30 benachbarter Dichtungselemente 10 miteinander verbinden. Zur Herstellung einer zuverlässigen Verbindung zwischen den Dichtungsabschnitten 62, 64, 66 und zugeordneten Dichtungen 28, 30 sind die Enden jedes Dichtungsabschnitts 62, 64, 66 mit jeweils einem Vorsprung 68 versehen, der beim Befestigen der Abdeckkappe 54 am Eckverbinder 44 in einen Hohlraum 70 einführbar ist, der durch das Dichtungsprofil gebildet ist, aus dem die Dichtungen 28, 30 bestehen.

Mit den Dichtungsabschnitten 62, 64, 66 versehene Abdeckkappen 54 können an einem aus Hohlprofilen 12 gebildeten Rahmen selbst dann mit Vorteil zum Einsatz kommen, wenn keine Dichtungselemente 10 Verwendung finden, denn die Dichtungsabschnitte 62, 64, 66 können dann z.B. als weiche Anschläge für beispielsweise eine Tür dienen, die an dem Rahmen befestigt ist.

## Patentansprüche

1. Dichtelement (10) für Hohlprofile (12), mit
- einem Dichtungsträger (16), der sich entlang einer Längsachse (A) erstreckt und zwei Schenkel (18, 20) mit je einer Außenseite (22) und einer Innenseite (24) aufweist, die an einander zugewandten Längsrändern einstückig miteinander so verbunden sind, dass sie zwischen sich einen Eckwinkel (α) einschließen,
- Dichtungen (28, 30), die an oder nahe einem freien Längsrand (26) jedes Schenkels (18, 20) parallel zum freien Längsrand (26) verlaufend auf der Außenseite (22) des zugehörigen Schenkels (18, 20) angebracht sind, und
- einer Befestigungseinrichtung an wenigstens einer Innenseite (24) eines Schenkels (18 oder 20) zum lösbaren Befestigen des Dichtelements (10) auf einer Ecke (14) eines Hohlprofils (12),
**dadurch gekennzeichnet, dass**
- die zwei Schenkel (18, 20) aus elastischem Material bestehen,
- der Eckwinkel (α) etwas kleiner ist als ein durch die Ecke des Hohlprofils (12) gebildeter Eckwinkel, auf der das Dichtelement befestigt werden soll, so dass die Schenkel (18, 20) beim Befestigen des Dichtelements (10) auseinandergedrückt werden, und
- die Befestigungseinrichtung durch wenigstens zwei Klemmflächen (36, 38) gebildet ist, von denen jeweils eine an der Innenseite (24) jedes Schenkels (18, 20) ausgebildet ist, so dass jede Klemmfläche (36, 38) beim Befestigen des Dichtelements (10) gegen eine Auflagefläche (40, 42) des Hohlprofils (12) gepresst wird, wobei jede Klemmfläche (36, 38) sich mit Abstand von den einander zugewandten Längsrändern der Schenkel (18, 20) parallel zur Längsachse (A) erstreckt und zwischen sich und der Innenseite (24) des zugehörigen Schenkels (18, 20) einen Klemmwinkel (β) einschließt.

2. Dichtelement nach Anspruch 1,
**dadurch gekennzeichnet, dass** jede Dichtung (28, 30) in einer längsverlaufenden Vertiefung (32) auf der Außenseite des zugehörigen Schenkels (18, 20) angeordnet ist, wobei ein den einander zugewandten Längsrändern der Schenkel (18, 20) näherer Längsrand der Vertiefung (32) durch die Rückseite der Klemmfläche (36 oder 38) dieses Schenkels (18 oder 20) gebildet ist.

3. Dichtelement nach einem der vorhergehenden Ansprüche,
**dadurch gekennzeichnet, dass** von der Außenseite (22) zumindest eines der Schenkel (18, 20) ein Steg (34) hervorragt, der sich parallel zur Längsachse (A) erstreckt und zwischen sich und der Außenseite (22) des zugehörigen Schenkels (18, 20) einen Federwinkel (γ) von weniger als 90 Grad einschließt.

4. Dichtelement nach einem der vorhergehenden Ansprüche,
**dadurch gekennzeichnet, dass** es aus einem elektrisch leitenden Material besteht.

5. Dichtelement nach einem der Ansprüche 1 bis 3,
**dadurch gekennzeichnet, dass** auf seine Außenseite einschließlich der Dichtungen (28, 30) eine elektrisch leitende Schicht aufgebracht ist.

6. Dichtelement nach Anspruch 5,
**dadurch gekennzeichnet, dass** die elektrisch leitende Schicht aufgedampft ist.

7. Dichtelement nach einem der vorhergehenden Ansprüche,
**dadurch gekennzeichnet, dass** es als ein 2K-Extrusionsteil ausgeführt ist.

8. Dichtungssystem für Hohlprofile,
gekennzeichnet durch wenigstens zwei Dichtelemente (10) nach einem der Ansprüche 1 bis 7 und wenigstens eine Abdeckkappe (54), die auf ihrer Außenseite mit einem oder mehreren Dichtungsabschnitten (62, 64, 66) versehen ist, die zur Verbindung mit Enden der Dichtungen (28, 30) des Dichtelements (10) ausgebildet sind.

9. Dichtungssystem nach Anspruch 8,
**dadurch gekennzeichnet, dass** auch die Abdeckkappe (54) einschließlich ihrer Dichtungsabschnitte (62, 64, 66) aus einem elektrisch leitenden Material besteht oder auf die Außenseite der Abdeckkappe (54) einschließlich ihrer Dichtungsabschnitte (62, 64, 66) eine elektrisch leitende Schicht aufgebracht ist.

## Claims

1. Sealing element (10) for hollow sections (12), comprising:
- a seal-carrier (16) that extends along a longitudinal axis (A) and has two arms (18, 20), each of which has an outer face (22) and an inner face (24) and which are connected together, as one piece, at longitudinal edges that face each other, such that they form a corner angle (α) between them;
- seals (28, 30) which are mounted on or near a free longitudinal edge (26) of each arm (18, 20), in a manner running parallel to said free longitudinal edge (26), on the outer face (22) of the arm (18, 20) in question; and
- a securing device, on at least one inner face (24) of an arm (18 or 20), for detachably mounting the sealing element (10) on a corner (14) of a hollow section (12),
**characterized in that**
- the two arms (18, 20) consist of elastic material;
- the corner angle (α) is slightly smaller than a corner angle which is formed by that corner of the hollow section (12) on which the sealing element is to be mounted, such that the arms (18, 20) are pressed apart when mounting the sealing element (10); and
- the securing device is formed by at least two clamping surfaces (36, 38), of which one is constructed, in each case, on the inner face (24) of each arm (18, 20), such that each clamping surface (36, 38) is pressed against a bearing surface (40, 42) of the hollow section (12) when mounting the sealing element (10), each clamping surface (36, 38) extending, at a distance from the longitudinal edges of the arms (18, 20) that face one another, parallel to the longitudinal axis (A), and forming a clamping angle (β) between itself and the inner face (24) of the associated arm (18, 20).

2. Sealing element according to Claim 1,
**characterized in that** each seal (28, 30) is arranged in a longitudinally extending recess (32) on the outer face of the associated arm (18, 20), one longitudinal edge of said recess (32), which edge is closer to those longitudinal edges of the arms (18, 20) that face one another, being formed by the rear face of the clamping surface (36 or 38) of the said arm (18 or 20).

3. Sealing element according to one of the preceding claims,
**characterized in that** there protrudes, from the outer face (22) of at least one of the arms (18, 20), a web (34) which extends parallel to the longitudinal axis (A) and forms, between itself and the outer face (22) of the arm (18, 20) in question, a spring angle (γ) of less than 90 degrees.

4. Sealing element according to one of the preceding claims,
**characterized in that** it consists of an electrically conductive material.

5. Sealing element according to one of Claims 1 to 3,
**characterized in that** an electrically conductive coating is applied to its outer face, including the seals (28, 30).

6. Sealing element according to Claim 5,
**characterized in that** the electrically conductive coating is vapour-deposited.

7. Sealing element according to one of the preceding claims,
**characterized in that** it is designed as a 2C extruded part.

8. Sealing system for hollow sections,
**characterized by** at least two sealing elements (10) according to one of Claims 1 to 7 and at least one cover cap (54) which is provided, on its outer face, with one or more sealing sections (62, 64, 66) which are constructed for connection to ends of the seals (28, 30) belonging to the sealing element (10).

9. Sealing system according to Claim 8,
**characterized in that** the cover cap (54), including its sealing sections (62, 64, 66), also consists of an electrically conductive material, or an electrically conductive coating is applied to the outer face of said cover cap (54), including its sealing sections (62, 64, 66).

## Revendications

1. Elément d'étanchéité (10) pour profilé creux (12), comprenant
- un support de garniture d'étanchéité (16) qui s'étend le long d'un axe longitudinal (A) et présente deux branches (18, 20) qui ont chacune un côté extérieur (22) et un côté intérieur (24) et sont reliées entre elles d'un seul tenant sur des bords longitudinaux tournés l'un vers l'autre de manière à former entre elles un angle de coin (α),
- des garnitures d'étanchéité (28, 30) qui sont posées sur un ou près d'un bord longitudinal libre (26) de chaque branche (18, 20) parallèlement au bord longitudinal libre (26) et s'étendent sur le côté extérieur (22) de la branche correspondante (18, 20), et
- un dispositif de fixation sur au moins un côté intérieur (24) d'une branche (18 ou 20) pour fixer de manière amovible l'élément d'étanchéité (10) sur un coin (14) du profilé creux (12)
**caractérisé en ce que**
- les deux branches (18, 20) sont constituées d'un matériau élastique,
- l'angle de coin (α) est légèrement inférieur à un angle de coin formé par le coin du profilé creux (12) sur lequel sera fixé l'élément d'étanchéité de manière à faire s'écarter les branches (18, 20) lors de la fixation de l'élément d'étanchéité (10), et
- le dispositif de fixation est formé par au moins deux surfaces de serrage (36, 38) dont chacune est réalisée sur le côté intérieur (24) de chaque branche (18, 20) si bien que chaque surface de serrage (36, 38) est pressée contre une surface d'appui (40, 42) du profilé creux (12) lors de la fixation de l'élément d'étanchéité (10), chaque surface de serrage (36, 38) s'étendant parallèlement à l'axe longitudinal (A) à distance des bords longitudinaux tournés l'un vers l'autre des branches (18, 20) et renfermant entre elle et le côté intérieur (24) de la branche correspondante (18, 20) un angle de serrage (β).

2. Elément d'étanchéité selon la revendication 1,
**caractérisé en ce que** chaque garniture d'étanchéité (28, 30) est disposée dans un creux (32) qui s'étend dans le sens de la longueur sur le côté extérieur de la branche correspondante (18, 20), un bord longitudinal du creux (32) situé plus près des bords longitudinaux tournés l'un vers l'autre des branches (18, 20) étant formé par le dos de la surface de serrage (36 ou 38) de cette branche (18 ou 20).

3. Elément d'étanchéité selon l'une des revendications précédentes,
**caractérisé en ce qu'**une nervure (34) fait saillie du côté extérieur (22) d'au moins une des branches (18, 20), laquelle nervure s'étend parallèlement à l'axe longitudinal (A) et renferme entre elle et le côté extérieur (22) de la branche (18, 20) correspondante un angle de ressort (γ) de moins de 90 degrés.

4. Elément d'étanchéité selon l'une des revendications précédentes,
**caractérisé en ce que** cet élément se compose d'un matériau électriquement conducteur.

5. Elément d'étanchéité selon l'une des revendications 1 à 3,
**caractérisé en ce qu'**une couche électriquement conductrice a été appliquée sur son côté extérieur, y compris sur les garnitures d'étanchéité (28, 30).

6. Elément d'étanchéité selon la revendication 5,
**caractérisé en ce que** la couche électriquement conductrice est appliquée par métallisation sous vide.

7. Elément d'étanchéité selon l'une des revendications précédentes,
**caractérisé en ce que** cet élément est réalisé sous la forme d'une pièce bi-composants extrudée.

8. Système d'étanchéité pour profilés creux,
**caractérisé par** au moins deux éléments d'étanchéité (10) selon l'une des revendications 1 à 7 et par au moins un capuchon (54) qui est pourvu sur son côté extérieur d'au moins une ou plusieurs sections de garniture d'étanchéité (62, 64, 66) conçues pour assurer la liaison avec des extrémités de garnitures d'étanchéité (28, 30) de l'élément d'étanchéité (10).

9. Système d'étanchéité selon la revendication 8,
**caractérisé en ce que** le capuchon (54), y compris ses sections de garniture d'étanchéité (62, 64, 66), se compose lui aussi d'un matériau électriquement conducteur ou **en ce qu'**une couche électriquement conductrice est appliquée sur le côté extérieur du capuchon (54), y compris sur ses sections de garniture d'étanchéité (62, 64, 66).
